# DEMANDE DE BREVET EUROPEEN

(11) **EP 0 949 683 A1**
(43) Date de publication de la demande: **13.10.1999**
(21) Numéro de dépôt: 99410020.4
(22) Date de dépôt: 26.03.1999
(51) Int. Cl.: H01L 29/739

(54) **Assemblage de diodes de type zener**

(30) Priorité: 26.03.1998 FR 9804007
(71) Demandeur: STMicroelectronics SA, 94250 Gentilly Cedex (FR)
(72) Inventeur: Boivin, Philippe, 13770 Venelles (FR)
(74) Mandataire: de Beaumont, Michel

(57) **Abrégé**

L'invention concerne un circuit intégré comprenant une pluralité de diodes à avalanche à tension de seuil réglable, chaque diode à avalanche comportant une structure de grille isolée (4) au-dessus du périmètre de la jonction de la diode, ladite jonction affleurant à la surface du composant, et des moyens pour polariser la grille. Des tensions distinctes choisies parmi les tensions existantes dans le circuit intégré en cours d'utilisation sont appliquées à chaque diode à avalanche.

## Description

La présente invention concerne l'utilisation de diodes à avalanche à seuil réglable dans des circuits intégrés, par exemple des circuits intégrés de puissance ou autres nécessitant des tensions de références multiples ou réglables tels que les mémoires à plusieurs niveaux de programmation.

Dans de tels circuits, on a souvent besoin de définir plusieurs seuils de déclenchement, par exemple pour réaliser divers dispositifs de protection contre des décharges électrostatiques, des inversions de batterie, et autres.

De façon générale dans un composant semiconducteur tel qu'un circuit intégré, on dispose de nombreuses couches et régions de types de conductivité donnés et de niveaux de dopage donnés destinées à former les divers composants élémentaires que contient le circuit intégré. Tout couple de régions de types de conductivité opposés dans lequel l'une des régions présente un niveau de dopage élevé peut être utilisé pour constituer une diode à avalanche.

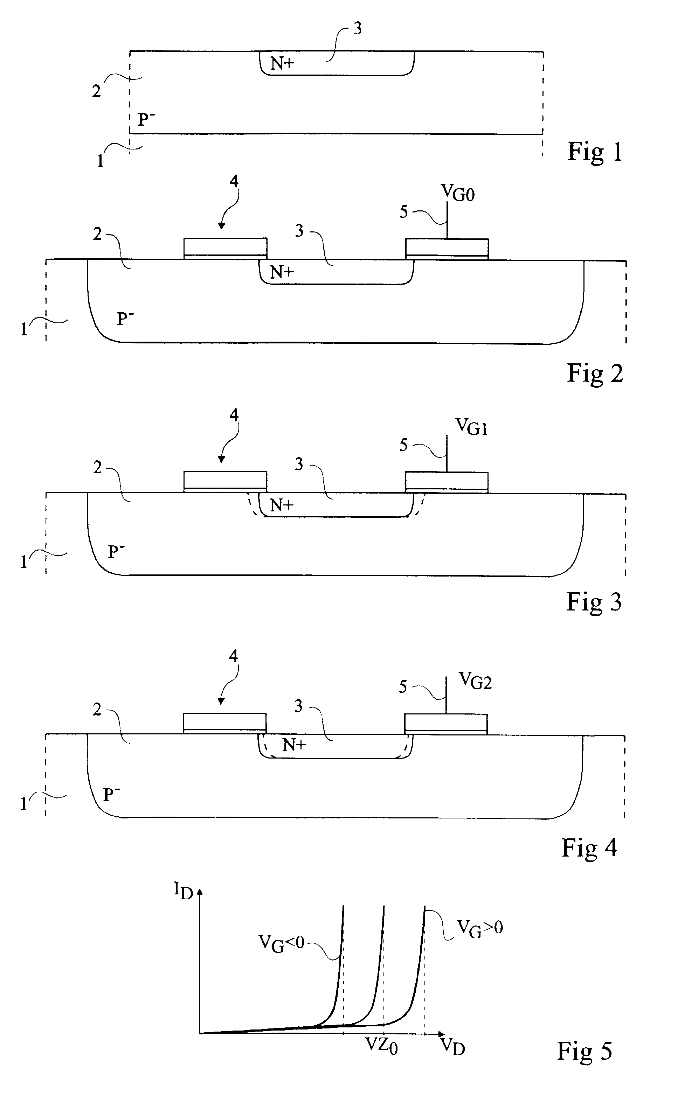

Par exemple, comme le représente la figure 1, une diode à avalanche peut être constituée dans un substrat semiconducteur 1, typiquement en silicium, d'un premier type de conductivité, ici le type N. Dans ce substrat est formée une région 2 faiblement dopée, de type P⁻ contenant une région 3 de type N⁺. On notera que le terme substrat est utilisé ici pour désigner une région ou couche supérieure d'un composant semiconducteur, par exemple un circuit intégré. La région 3 est généralement fortement dopée, et le seuil de claquage de la diode à avalanche est essentiellement déterminé par le niveau de dopage de la région 2 (moins la région 2 est dopée, plus la tension de claquage du dispositif est élevée). Des électrodes d'anode et de cathode (non représentées) sont solidaires des régions 2 et 3.

Dans des dispositifs nécessitant plusieurs références de tension distinctes, il faut disposer de diodes à seuils d'avalanche distincts et spécifiques. Les couples existants de régions P-N sont donc insuffisants et il faudrait prévoir des étapes d'implantation à des doses spécifiques. Ceci signifie qu'il faudrait prévoir, dans une technologie donnée, des étapes de traitement supplémentaires. Il en résulterait des composants plus complexes à fabriquer et plus coûteux.

Un objet de la présente invention est de prévoir un assemblage de diodes à avalanche de seuils distincts en utilisant des jonctions existantes dans une filière déterminée, ce seuil pouvant être choisi sans ajouter d'étapes supplémentaires de dopage.

Pour atteindre cet objet, la présente invention prévoit un circuit intégré comprenant une pluralité de diodes à avalanche à tension de seuil réglable, chaque diode à avalanche comportant une structure de grille isolée au-dessus du périmètre de la jonction de la diode, ladite jonction affleurant à la surface du composant, et des moyens pour polariser la grille. Des tensions distinctes choisies parmi les tensions existantes dans le circuit intégré en cours d'utilisation sont appliquées à chaque diode à avalanche.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une diode à avalanche selon l'art antérieur ;
les figures 2 à 4 représentent des diodes à avalanche à seuil variable ;
la figure 5 illustre la caractéristique tension-courant d'une diode à avalanche à seuil variable ; et
les figures 6 à 8 illustrent schématiquement et vues en coupe différentes étapes de fabrication d'une diode à avalanche à seuil variable.

Par souci de clarté, et comme cela est habituel dans la représentation des circuits intégrés, les différentes figures ne sont pas à l'échelle. De plus, de mêmes éléments sont désignés par de mêmes références.

La figure 2 représente vue en coupe la structure d'une diode à avalanche à seuil variable. La structure comprend une région 2 d'un premier type de conductivité qui sera considéré ci-après à titre d'exemple comme le type P⁻, formée dans un substrat 1. Cette région 2 contient une région 3 de type N⁺. Des électrodes d'anode et de cathode (non représentées) sont solidaires des régions 2 et 3, respectivement.

La diode comporte une structure de grille isolée 4. Cette grille isolée est placée au-dessus de la jonction de la diode, c'est-à-dire au-dessus de la frontière entre les régions 2 et 3. Une électrode 5 est solidaire de la grille 4.

Comme l'illustrent les figures 2 à 4, lorsqu'on applique une tension V_{G} à la grille 4, le champ créé équivaut à une modification de la forme de la jonction P-N⁺ au voisinage de la surface sous la grille. Il en résulte une modification de la tension d'avalanche.

L'application d'une tension positive sur la grille équivaut, comme cela est représenté en pointillés en figure 3, à réduire le rayon de courbure de la jonction N⁺-P⁻ ou, en d'autres termes, à évaser la région N⁺, ce qui tend à augmenter la tension d'avalanche.

Inversement, l'application d'une tension négative sur la grille équivaut, comme cela est représenté en pointillés en figure 4, à rétracter la région N⁺, ce qui tend à diminuer la tension d'avalanche.

La figure 5 illustre la variation de la tension d'avalanche V_{Z} de la diode avec la variation de la tension de polarisation V_{G} correspondant aux figures 2 à 4.

Ainsi, pour une structure de jonction donnée, on peut former une diode de tension d'avalanche variable en fonction de la tension appliquée sur une grille.

Des diodes à avalanche du type décrit ci-dessus sont par exemple décrites dans GB-A-1138799 et dans GB-A-2125215.

Selon la présente invention, on formera simultanément plusieurs jonctions identiques dont les limites superficielles sont recouvertes d'une grille isolée et on appliquera aux diverses grilles des tensions différentes, choisies parmi les tensions normalement appliquées aux composants élémentaires d'un circuit intégré dans lequel les diodes sont incorporées. Bien entendu, pour une optimisation des valeurs d'avalanche, les tensions du circuit pourront être ajustées, par exemple, en utilisant des diviseurs de tension, eux-mêmes incorporés dans le circuit intégré.

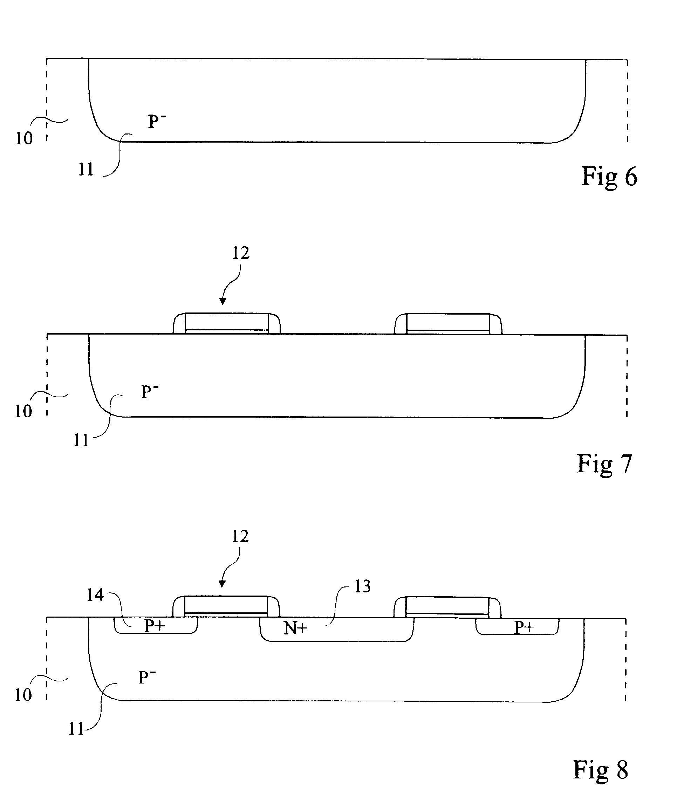

En pratique, la diode à avalanche à seuil variable peut-être obtenue par le procédé illustré en figures 6 à 8.

Comme le représente la figure 6, on commence par créer dans un substrat semiconducteur 10, typiquement en silicium, une région 11 faiblement dopée, de type P⁻, destinée à former une première électrode, ou anode, de la diode.

Aux étapes suivantes, illustrées en figure 7, on crée une structure de grille isolée 12, de préférence circulaire. On notera que dans un circuit intégré de type MOS, CMOS ou BICMOS, la réalisation de cette grille ne rajoute pas d'étapes supplémentaires au procédé de fabrication.

Aux étapes suivantes, illustrées en figure 8, on effectue successivement deux implantations afin de former, à l'intérieur du contact de la grille 12, une région 13 fortement dopée de type N⁺ et, à l'extérieur de la grille 12, une région 14 fortement dopée de type P⁺, destinée à constituer une zone de reprise de contact très conductrice avec une métallisation.

Enfin, on forme des métallisations (non représentées) en contact avec chacune des régions 12, 13 et 14, destinées à former respectivement des électrodes de grille, de cathode et d'anode.

Un avantage de la présente invention est de ne pas nécessiter d'étapes de dopage (diffusion, implantation/diffusion, recuit) autres que celles normalement utilisées pour la fabrication d'un circuit intégré donné.

Bien que la présente invention ait été décrite dans le cadre d'un mode de réalisation particulier, elle est susceptible de nombreuses variantes et modifications qui apparaîtront à l'homme de l'art. Notamment, elle s'applique également à l'utilisation de diodes à avalanche de type P⁺-N. Alors, l'effet de la tension de grille est inversé. En d'autres termes, pour avoir une diminution de la tension de seuil de la diode, il faut augmenter la tension de grille appliquée.

## Revendications

1. Circuit intégré comprenant une pluralité de diodes à avalanche à tension de seuil réglable, chaque diode à avalanche comportant une structure de grille isolée (4) au-dessus du périmètre de la jonction de la diode, ladite jonction affleurant à la surface du composant, et des moyens pour polariser la grille, caractérisé en ce que des tensions distinctes choisies parmi les tensions existantes dans le circuit intégré en cours d'utilisation sont appliquées à chaque diode à avalanche.
